# FASCICULE DE BREVET EUROPEEN

(11) **EP 0 561 718 B1**
(45) Date de publication et mention de la délivrance du brevet: **12.06.1996**
(21) Numéro de dépôt: 93420115.3
(22) Date de dépôt: 15.03.1993
(51) Int. Cl.: H03L 7/089, H03D 13/00

(54) **Comparateur de phase/fréquence**
Phasen- und Frequenzkomparator
Phase and frequency comparator

(30) Priorité: 17.03.1992 FR 9203547
(43) Date de publication de la demande: 22.09.1993
(73) Titulaire: SGS-THOMSON MICROELECTRONICS S.A., F-94250 Gentilly (FR)
(72) Inventeur: Debaty, Pascal, F-38420 Domene (FR)
(74) Mandataire: de Beaumont, Michel

(56) Documents cités:
- GB-A- 2 055 268
- GB-A- 2 075 294
- IEEE JOURNAL OF SOLID-STATE CIRCUITS. no. 2, 1987, NEW YORK US pages 255 - 261 DEOG-KYOON JEONG ET AL. 'Design of PLL-Based Clock Generation Circuits'

## Description

La présente invention concerne les comparateurs de phase/fréquence utilisés dans les boucles à verrouillage de phase. Elle concerne plus particulièrement des comparateurs à deux entrées et deux sorties, la première sortie fournissant un signal quand la première entrée est en avance sur la seconde et la deuxième sortie fournissant un signal quand la deuxième entrée est en avance sur la première.

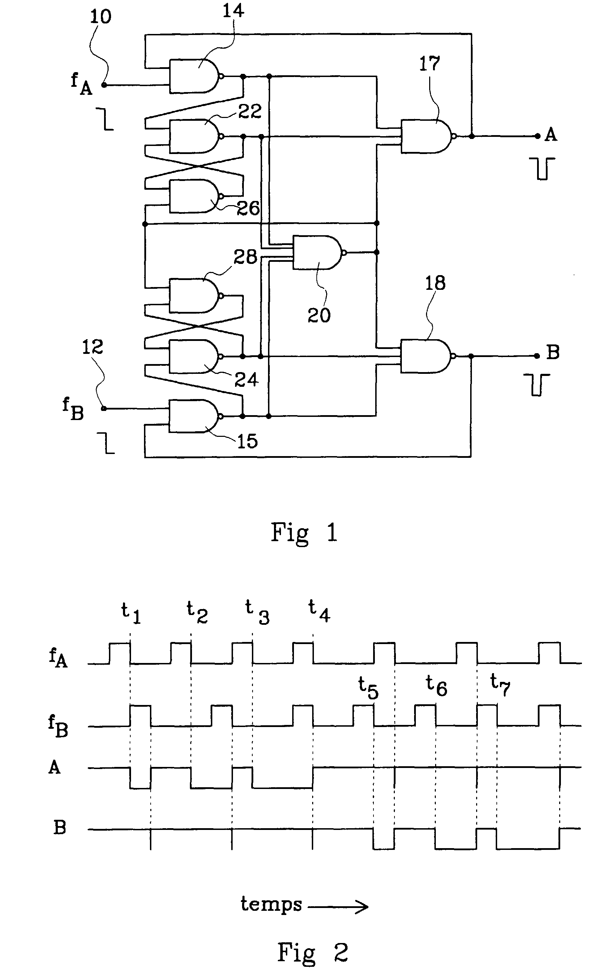

La figure 1 illustre un comparateur de phase/fréquence couramment utilisé dans les boucles à verrouillage de phase à pompe de charge. Un tel comparateur et son utilisation sont décrits dans le brevet des Etats-Unis d'Amérique N° 3 610 954.

Des signaux d'entrée f_{A} et f_{B} dont les phases et/ ou les fréquences doivent être comparées sont sous la forme de signaux rectangulaires et sont appliqués respectivement à des bornes d'entrée 10 et 12. Chacune de ces bornes d'entrée est reliée à une première entrée d'une porte NON ET respective 14 et 15. La sortie de chacune des portes NON ET 14 et 15 est reliée à une première entrée d'une porte NON ET respective 17 et 18, la sortie de cette porte NON ET 17 ou 18 étant rebouclée sur une deuxième entrée de la porte respective 14 et 15. Les sorties des portes 17 et 18 sont reliées à des bornes de sortie A et B.

La sortie de chacune des portes 14 et 15 est également rel iée à une entrée respective d'une porte NON ET 20 et à une entrée d'une porte NON ET respective 22 et 24. Chacune des portes 22 et 24 forme avec une porte NON ET respective 26 et 28 un circuit de mémorisation temporaire (latch). Dans chaque circuit de mémorisation, la sortie d'une première des portes est rebouclée sur une entrée libre de la deuxième porte et la sortie de la deuxième porte est rebouclée sur une entrée libre de la première porte. La sortie de chacune des portes 22 et 24 est reliée à une deuxième entrée de la porte respective 17 et 18 et à une autre entrée respective de la porte 20. La sortie de la porte 20 est reliée à une troisième entrée des portes 17 et 18 et aux entrées restantes des portes 26 et 28.

Au repos, les sorties A et B sont à 1 et les signaux f_{A} et f_{B} sont supposés à 1. Dans ce cas, les portes 14, 15, 26 et 28 sont à 0 et les portes 20, 22 et 24 sont à 1. Si par exemple le signal f_{A} passe à 0, la porte 14 passe à 1. Alors, les trois entrées de la porte 17 sont à 1 et sa sortie A passe à 0. En passant à 0, la sortie A verrouille l'état de la porte 14, c'est-à-dire que, quel que soit l'état du signal f_{A}, la porte 14 reste à 1. L'état de la porte 17 (donc de la sortie A) n'est donc plus modifiable par le signal f_{A}. En outre, le changement d'état de la porte 14 n'a eu aucun effet sur le circuit de mémorisation 22-26, la sortie de la porte 22 restant à 1.

Lorsque le signal f_{B} passe à 0, la porte 15 passe à 1. Toutes les entrées de la porte 20 se trouvent à 1. Alors, la porte 20 passe à 0, ce qui force les sorties A et B à 1. Ainsi, la sortie A est passée à 0 entre un front descendant du signal f_{A} et le front descendant suivant du signal f_{B}. Théoriquement, l'état de la sortie B ne varie pas durant ce temps.

Par ailleurs, le passage à zéro de la porte 20 commute les états des circuits de mémorisation 22-26 et 24-28, ce qui a pour effet de conserver toujours l'état 1 des sorties A et B et de forcer la porte 20 à 1. Ceci permet aux sorties A et B de garder leur état 1 quels que soient les instants où se produisent les fronts montants des signaux f_{A} et f_{B} ultérieurs au front descendant du signal f_{A}. Le circuit de mémorisation 22-26 retrouve son état initial dès que le signal f_{A} et la sortie A sont à 1 et le circuit 24-28 retrouve son état initial dès que le signal f_{B} et la sortie B sont à 1.

La figure 2 représente un exemple des allures des signaux f_{A} et f_{B} et des signaux de sortie correspondants sur les bornes A et B. On a représenté les signaux f_{A} et f_{B} tels que, jusqu'à un instant t₄, la fréquence du signal f_{A} est supérieure à celle du signal f_{B} et inversement après l'instant t₄.

A des instants t₁, t₂ et t₃, les fronts descendants du signal f_{A} surviennent avant les fronts descendants correspondants du signal f_{B}. Alors, comme cela a été décrit en relation avec la figure 1 et comme cela est représenté, la sortie A passe à zéro entre chaque front descendant du signal f_{A} et le front descendant suivant du signal f_{B}.

A des instants t₅, t₆ et t₇, les fronts descendants du signal f_{B} surviennent avant les fronts descendants correspondants du signal f_{A}. Alors, comme cela est représenté, la sortie B passe à zéro entre chaque front descendant du signal f_{B} et le front descendant suivant du signal f_{A}.

Les explications précédentes ont été données en supposant que les diverses portes commutent instantanément dès que leurs signaux d'entrée commutent. Ici n'est bien entendu pas exact en pratique et chaque porte présente un certain temps de commutation. Il en résulte l'apparition d'impulsions parasites. En particulier, quand un front descendant du signal f_{B} apparaît sur l'entrée 12 après un front descendant sur l'entrée 10, cela produit, de la façon indiquée, le basculement séquentiel des portes 15, 20 et 17 et ne devrait pas avoir d'effet sur la porte 18. Mais comme la porte 15 est connectée à la porte 18, celle-ci a temporairement toutes ses entrées à 1 avant d'être inhibée par le basculement de la porte 20. Il en résulte une courte impulsion parasite sur la sortie B d'environ la durée du temps de commutation de la porte 20.

On a également représenté en figure 2 les impulsions parasites susmentionnées. Ces impulsions parasites se produisent sur la sortie A à chaque front descendant du signal f_{A} après l'instant t₄ et se produisent sur la sortie B à chaque front descendant du signal f_{B} avant l'instant t₄.

La demande de brevet anglais 2 055 268 décrit un comparateur de phase du type de celui de la figure 1 réalisé en technologie CMOS très lente. La lenteur de commutation des portes logiques formant le comparateur de phase entraîne, outre les impulsions parasites courtes susmentionnées, des impulsions parasites longues se produisant sur les deux sorties à la fois. Pour supprimer ces impulsions parasites longues, il est prévu un système de portes logiques croisées disposé après les deux sorties du comparateur de phase. Toutefois, ce système ne supprime pas les impulsions parasites courtes se produisant lors des fronts descendants des signaux d'entrée f_{A} et f_{B}.

Dans le cas où les sorties A et B pilotent respectivement des sources de courant de charge et de décharge d'une capacité, comme dans le cas du circuit de la demande de brevet susmentionnée, les impulsions parasites courtes sont tellement brèves qu'elles ont une influence négligeable sur la charge de la capacité et on peut donc les tolérer. Toutefois, dans certaines applications, par exemple si on commande un circuit numérique à partir des sorties A et B, les impulsions parasites, même très courtes, ne sont plus tolérables.

Un objet de la présente invention est de prévoir un comparateur de phase/fréquence, du type permettant de commander une boucle à verrouillage de phase à pompe de charge, ne présentant aucune impulsion parasite à ses sorties.

Cet objet est atteint grâce à un comparateur de phase/ fréquence comme défini par la revendication 1.

Selon un mode de réalisation de la présente invention, les première et deuxième portes sont des portes NON ET et les premier et deuxième moyens interrupteurs sont des portes ET, une entrée de la première porte ET étant reliée à la sortie de la deuxième porte NON ET, et une entrée de la deuxième porte ET étant reliée à la sortie de la première porte NON ET.

Ces objets, caractéristiques, et avantages ainsi que d'autres de la présente invention seront exposés en détail dans la description suivante de modes de réalisation particuliers faite en relation avec les figures jointes parmi lesquelles :
la figure 1, précédemment décrite, représente un comparateur de phase/fréquence classique pour une boucle à verrouillage de phase à pompe de charge ;
la figure 2, précédemment décrite, illustre des allures de signaux relatifs au circuit de la figure 1 ; et
la figure 3 représente un mode de réalisation de comparateur de phase/fréquence selon la présente invention.

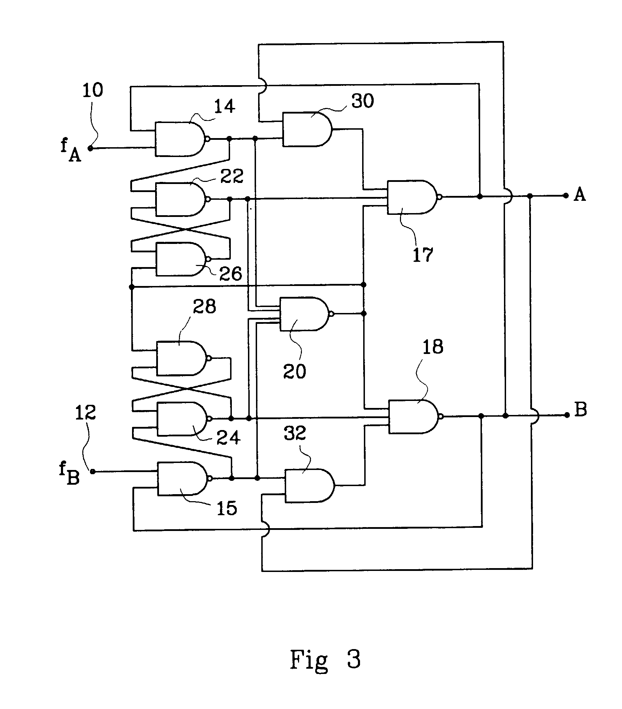

A la figure 3, on retrouve les mêmes éléments qu'à la figure 1 désignés par des mêmes références.

Selon l'invention, les sorties des portes 14 et 15 ne sont pas reliées directement aux portes 17 et 18. Les sorties des portes 14 et 15 sont reliées respectivement à une entrée d'une porte ET 30 et à une entrée d'une porte ET 32. Les sorties des portes 30 et 32 sont respectivement reliées aux portes 17 et 18. Une deuxième entrée de la porte 30 est reliée à la sortie B et une deuxième entrée de la porte 32 est reliée à la sortie A.

En supposant que la sortie A vient de passer à 0 à cause d'un front descendant du signal f_{A}, la porte 32 reste à 0 même quand la porte 15 passe à 1 lors du front descendant suivant du signal f_{B}. La sortie B reste donc à 1. L'état 1 de la porte 15 n'est transmis vers la porte 18 que lorsque la sortie A sera passée à 1 après la commutation de la porte 20. Les impulsions parasites sur la sortie B sont donc inhibées pendant le temps de commutation de la porte 20.

En supposant que la sortie B vient de passer à 0 à cause d'un front descendant du signal f_{B}, la porte 30 reste à 0 même quand la porte 14 passe à 1 lors du front descendant suivant du signal f_{A}. La sortie A reste donc à 1. L'état 1 de la porte 14 n'est transmis vers la porte 17 que lorsque la sortie B sera passée à 1 après la commutation de la porte 20. Les impulsions parasites sur la sortie A sont donc inhibées pendant le temps de commutation de la porte 20.

La présente invention a été décrite en relation avec un exemple précis utilisant des types particuliers de porte logique fonctionnant en logique négative. L'homme du métier saura choisir les portes 30 et 32 convenablement selon le type des portes utilisées dans le comparateur de phase/fréquence.

Plus généralement, les portes 30 et 32 peuvent être considérées comme des interrupteurs disposés entre les portes 14 et 17 d'une part, et 15 et 18 d'autre part, ces interrupteurs étant coupés par l'état actif des sorties A ou B (0 dans l'exemple décrit ), empêchant alors la transmission vers les portes 17 et 18 d'un état (1) susceptible de faire basculer ces portes.

## Revendications

1. Comparateur de phase/fréquence comprenant :
- deux entrées (10, 12) recevant respectivement des premier et deuxième signaux logiques (f_{A}, f_{B}) ;
- une première porte logique (17) fournissant une première sortie (A) du comparateur, active pendant une durée égale aux avances de phase du premier signal par rapport au deuxième ;
- une deuxième porte logique (18) fournissant une deuxème sortie (B) du comparateur, active pendant une durée égale aux avances de phase du deuxième signal par rapport au premier ;et
- une pluralité de portes logiques, dont les première et deuxième, interconnectées entre les deux entrées et les deux sorties ;
caractérisé en ce qu'il comprend :
- un premier moyen interrupteur (30) actionné par l'état actif de la deuxième porte pour empêcher la transmission vers la première porte d'un état susceptible de faire basculer la première porte à son état actif ; et
- un deuxième moyen interrupteur (32) actionné par l'état actif de la première porte pour empêcher la transmission vers la deuxième porte d'un état susceptible de faire basculer la deuxième porte à son état actif.

2. Comparateur selon la revendication 1, caractérisé en ce que les première et deuxième portes (17, 18) sont des portes NON ET et en ce que les premier et deuxième moyens interrupteurs sont des portes ET (30, 32), une entrée de la première porte ET étant reliée à la sortie de la deuxième porte NON ET, et une entrée de la deuxième porte ET étant reliée à la sortie de la première porte NON ET.

3. Comparateur selon la revendication 1, caractérisé en ce qu'il comprend :
- des première et deuxième bascules (22, 26 ; 24, 28) ayant chacune des première et deuxième entrées de commande complémentaires ;
- des troisième et quatrième portes logiques (14, 15) ayant des premières entrées respectives recevant respectivement les premier et deuxième signaux logiques, des deuxièmes entrées respectives connectées respectivement aux première et deuxième sorties, et des sorties respectives, connectées respectivement aux premières entrées de commande des première et deuxième bascules;
- une cinquième porte logique (20) ayant quatre entrées connectées respectivement aux sorties des troisième et quatrième portes logiques (14, 15) et des première et deuxième bascules, et une sortie connectée aux deuxièmes entrées de commande des première et deuxième bascules ;
- des sixième et septième portes logiques (30, 32) ayant des premières entrées respectives connectées respectivement aux sorties des troisième et quatrième portes logiques (14, 15), et des deuxièmes entrées respectives connectées respectivement aux deuxième (B) et première (A) sorties ; et
- les deuxième et première portes logiques (17, 18) ayant des premières entrées respectives connectées respectivement aux sorties des sixième et septième portes logiques (30, 32), des deuxièmes entrées respectives connectées respectivement aux sorties des première et deuxième bascules, et des troisièmes entrées respectives connectées à la sortie de la cinquième porte logique (20).

## Patentansprüche

1. Phasen- und Frequenzkomparator mit:
- zwei Eingängen (10, 12), die erste bzw. zweite logische Signale (f_{A}, f_{B}) empfangen;
- einem ersten logischen Tor (17), das einen ersten Ausgang (A) des Komparators liefert und während einer Zeitspanne aktiv ist, die gleich der Phasenvoreilung des ersten Signales in bezug zu dem zweiten ist;
- einem zweiten logischen Tor (18), das einen zweiten Ausgang (B) des Komparators liefert und während einer Zeitspanne aktiv ist, die gleich der Phasenvoreilung des zweiten Signales in bezug zu dem ersten ist; und
- mehreren jeweils ersten und zweiten logischen Toren, die zwischen die beiden Eingänge und die beiden Ausgänge geschaltet sind;
dadurch gekennzeichnet, daß er aufweist:
- eine erste Schalteinheit (30), die durch den aktiven Zustand des zweiten Tores betätigt wird, um das Senden eines Zustandes an das erste Tor, durch den das erste Tor in den aktiven Zustand umgeschaltet werden könnte, zu verhindern; und
- eine zweite Schalteinheit (32), die durch den aktiven Zustand des ersten Tores betätigt wird, um das Senden eines Zustandes an das zweite Tor, durch den das zweite Tor in den aktiven Zustand umgeschaltet werden könnte, zu verhindern.

2. Komparator nach Anspruch 1, dadurch gekennzeichnet, daß das erste und zweite Tor (17, 18) NAND-Tore sind, und daß die erste und zweite Schalteinheit UND-Tore (30, 32) sind, wobei ein Eingang des ersten UND-Tores mit dem Ausgang des zweiten NAND-Tores verbunden ist und ein Eingang des zweiten UND-Tores mit dem Ausgang des ersten NAND-Tores verbunden ist.

3. Komparator nach Anspruch 1, dadurch gekennzeichnet, daß er aufweist:
- erste und zweite Schalteinrichtungen (22, 26; 24, 28), die jeweils erste und zweite komplementäre Befehlseingänge aufweisen;
- dritte und vierte logische Tore (14, 15) mit jeweils ersten Eingängen, die die ersten bzw. zweiten logischen Signale empfangen, mit jeweils zweiten Eingängen, die mit dem ersten bzw. zweiten Ausgang verbunden sind, und jeweils mit Ausgängen, die mit den ersten Befehlseingängen der ersten bzw. zweiten Schalteinrichtung verbunden sind;
- ein fünftes logisches Tor (20) mit vier Eingängen, die mit den Ausgängen des dritten bzw. vierten logischen Tores (14, 15) bzw. der ersten und zweiten Schalteinrichtung verbunden sind, und mit einem Ausgang, der mit den zweiten Befehlseingängen der ersten und zweiten Schalteinrichtung verbunden ist;
- sechste und siebente logische Tore (30, 32) mit jeweils ersten Eingängen, die mit den Ausgängen des dritten bzw. vierten logischen Tores (14, 15) verbunden sind, und mit jeweils zweiten Eingängen, die mit dem zweiten (B) bzw. ersten (A) Ausgang verbunden sind; und
- die ersten und zweiten logischen Tore (17, 18) mit jeweils ersten Eingängen, die mit den Ausgängen des sechsten bzw. siebenten logischen Tores verbunden sind, mit jeweils zweiten Eingängen, die mit den Ausgängen der ersten bzw. zweiten Schalteinrichtung verbunden sind, und mit jeweils dritten Eingängen, die mit dem Ausgang des fünften logischen Tores (20) verbunden sind.

## Claims

1. A phase/frequency comparator including:
- two inputs (10, 12) respectively receiving first and second logic signals (f_{A}, f_{B});
- a first logic gate (17) providing a first output (A) of the comparator, being at an active state during a duration equal to the phase advance of said first signal with respect to said second signal;
- a second logic gate (18) providing a second output (B) of the comparator, being at an active state during a duration equal to the phase advance of said second signal with respect to said first signal; and
- a plurality de logic gates, including said first and second gates, interconnected between the two inputs and the two outputs;
characterized in that it comprises:
- first switching means (30) operated by the active state of said second gate to prevent transmission to said first gate of a state capable of switching said first gate to its active state; and
- second switching means (32) operated by the active state of said first gate to prevent transmission to said second gate of a state capable of switching said second gate to its active state.

2. A comparator according to claim 1, characterized in that said first and second gates (17, 18) are NAND gates, and said first and second switching means are AND gates (30, 32), an input of said first AND gate being connected to the output of said second NAND gate, and an input of said second AND gate being connected to the output of said first NAND gate.

3. A comparator according to claim 1, characterized in that it comprises:
- a first and second latches (22,26; 24,28), each having first and second complementary control inputs;
- third and fourth gates (14, 15) having respective first inputs respectively receiving said first and second logic signals, respective second inputs respectively connected to said first and second outputs, and respective outputs respectively connected to the first control inputs of the first and second latches;
- a fifth gate (20) having four inputs respectively connected to the outputs of the third and fourth gates (14, 15) and of the first and second latches, and an output connected to the second control inputs of the first and second latches;
- sixth and seventh gates (30, 32) having respective first inputs respectively connected to the outputs of the third and fourth gates (14, 15), and respective second inputs respectively connected to the second (B) and first (A) outputs; and
- said second and first gates (17, 18) having respective first inputs respectively connected to the outputs of the sixth and seventh gates (30, 32), respective second inputs respectively connected to the outputs of the first and second latches, and respective third inputs connected to the output of the fifth gate (20).
